# FASCICULE DE BREVET EUROPEEN

(11) **EP 2 426 698 B1**
(45) Date de publication et mention de la délivrance du brevet: **28.09.2022**
(21) Numéro de dépôt: 11178220.7
(22) Date de dépôt: 22.08.2011
(51) Int. Cl.: H01L 21/02, H01L 49/02

(54) **Capacité intégrée comprenant une couche d'isolation électrique en matériau de type pérovskite amorphe et procédé de fabrication**
Integrierter Kondensator, der eine elektrische Isolierschicht aus amorphem Perovskit umfasst, und Herstellungsverfahren dafür
Integrated capacitance including an electric insulation layer made of an amorphous perovskite material and manufacturing method therefor

(30) Priorité: 03.09.2010 FR 1003527
(43) Date de publication de la demande: 07.03.2012
(73) Titulaire: COMMISSARIAT À L'ÉNERGIE ATOMIQUE ET AUX ÉNERGIES ALTERNATIVES, 75015 Paris (FR)
(72) Inventeur: Defay, Emmanuel, 38340 Voreppe (FR); Le Rhun, Gwenaël, 38140 Renage (FR); Suhm, Aurélien, 38100 Grenoble (FR)
(74) Mandataire: Atout PI Laplace

(56) Documents cités:
- EP-A2- 1 217 658
- US-A1- 2001 001 488
- US-A1- 2002 175 361
- US-A1- 2004 130 849
- US-A1- 2007 196 932
- XU Y ET AL: "Electrical characterizations of polycrystalline and amorphous thin films of Pb(ZrxTi1-x)O3 and BaTiO3 prepared by sol-gel technique", JOURNAL OF NON-CRYSTALLINE SOLIDS, NORTH-HOLLAND PHYSICS PUBLISHING. AMSTERDAM, NL, vol. 176, no. 1, 2 octobre 1994 (1994-10-02), pages 1-17, XP024061984, ISSN: 0022-3093, DOI: DOI:10.1016/0022-3093(94)90205-4 [extrait le 1994-10-02]
- GONG W ET AL: "Effect of pyrolysis temperature on preferential orientation and electrical properties of sol-gel derived lead zirconate titanate films", JOURNAL OF THE EUROPEAN CERAMIC SOCIETY, ELSEVIER SCIENCE PUBLISHERS, BARKING, ESSEX, GB, vol. 24, no. 10-11, 1 septembre 2004 (2004-09-01), pages 2977-2982, XP004504401, ISSN: 0955-2219, DOI: DOI:10.1016/J.JEURCERAMSOC.2003.10.007

## Description

Le domaine de l'invention est celui des composants de type capacité intégrée comprenant une couche de diélectrique comprise entre une électrode supérieure et une électrode inférieure et avec reprise de contact, nécessitant l'utilisation d'isolant électrique entre les deux types d'électrodes.

Typiquement ce type de composant peut être utilisé dans le cadre d'actionneurs piézoélectriques, notamment pour l'optique adaptative ou des actionneurs pour imprimantes à jet d'encre. De tels composants peuvent également être utilisés pour réaliser des résonateurs et des filtres radiofréquences acoustiques utilisant un effet piézoélectrique pour la téléphonie mobile. Ils sont également intéressants pour l'élaboration de capacités variables ferroélectriques, de capacités à très fortes valeurs utilisées pour la téléphonie mobile ou les objets nomades en général (pacemaker, objets communicants).

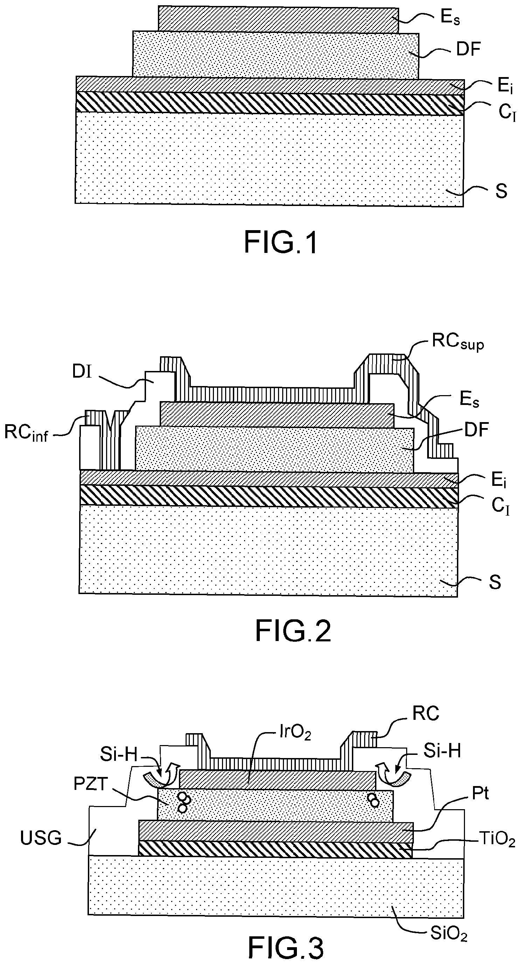

Actuellement pour réaliser des capacités intégrées en technologie plane (appelée MIM pour Métal Isolant Métal), on a besoin de reprendre les contacts électriques sur les électrodes. En effet, une structure typique de capacité MIM comporte une couche de diélectrique dit fonctionnel DF en sandwich entre deux électrodes Es et Ei, l'électrode inférieure étant à la surface d'un substrat S recouvert d'une couche isolante Ci comme illustré en figure 1.

Pour reprendre les contacts via une couche de reprise de contacts RCₛᵤₚ et RC_{inf}, et pour éviter le court circuit entre les électrodes supérieure et inférieure, il est nécessaire d'utiliser un diélectrique d'isolation DI comme illustré sur la figure 2.

Ce diélectrique d'isolation peut être un oxyde de silicium SiO₂ déposé par PECVD, par pulvérisation, ou par un dépôt à la tournette couramment identifié par l'acronyme « SOG » pour « Spin On Glass » par exemple. Cela peut être aussi un nitrure de silicium SiₓN_{y} déposé par PECVD, LPCVD par exemple, il pourrait tout aussi bien s'agir d'autres matériaux isolants tels que les composés suivants : Ta₂O₅, Al₂O₃, MgO, AlN...

Une contrainte pour ce diélectrique d'isolation DI est qu'il ne doit pas perturber le fonctionnement du diélectrique fonctionnel DF. En particulier, il est important que la capacité qu'il rajoute en parallèle sur le dispositif soit négligeable par rapport à la capacité fonctionnelle. Pour ce faire, l'état de l'art utilise un diélectrique d'isolation DI de constante diélectrique faible par rapport au diélectrique fonctionnel DF.

Par exemple, si le diélectrique fonctionnel DF est du Pb(Zr,Ti)O₃ (PZT) dont la constante diélectrique vaut typiquement 1000, il est courant d'utiliser un oxyde de silicium comme diélectrique d'isolation DI dont la constante diélectrique vaut 4. Ainsi, la capacité ajoutée par le SiO₂ sera beaucoup plus faible que la capacité de PZT, à surface équivalente donnée.

Pour le PZT et autres oxydes à très forte permittivité, l'utilisation du diélectrique d'isolation DI peut poser un problème de fiabilité. En effet, Bouyssou et al. (thèse Emilien Bouyssou, p.20, thèse de l'Université de Tours, 2006), ont observé que le SiO₂ utilisé comme diélectrique d'isolation DI est à l'origine de l'apparition d'une fragilité dans des capacités de PZT, plus précisément d'un vieillissement prématuré des condensateurs en test de contrainte en tension constante. Ceci est expliqué par les composés hydrogénés utilisés lors des dépôts CVD des diélectriques d'isolation DI, méthode la plus couramment utilisée dans l'industrie et notamment illustré en figure 3, recouvert d'une couche USG (pour « Undoped Silicon Glass) avec reprise de contact Rc.

Il est connu du Document US 2001/001488, une capacité comprenant une première couche active de matériau ferroélectrique et également une seconde couche de matériau ferroélectrique destinée à protéger la première couche contre l'intrusion d'atomes d'hydrogène H qui pourraient être piégés dans une couche d'isolant électrique à base d'oxyde, une couche de matériau diélectrique 24 est de plus prévue pour assurer l'isolation des contacts électriques. Ce Document propose d'encapsuler le premier ferroélectrique par un second, sans proposer d'utiliser celui-ci comme isolant électrique, puisqu'il est par ailleurs prévu d'utiliser en plus une couche d'isolant électrique.

Il est également décrit dans le Document US 2007/0196932, le même type de configuration que celle du Document US 2001/00148, soit un empilement de couches suivant :
- une électrode inférieure 14 ;
- une couche de diélectrique de ferroélectrique de type PZT 15 ;
- une électrode supérieure 16 ;
- une seconde couche de diélectrique ferroélectrique de type PZT 17 ;
- une couche d'isolation électrique 18 (par exemple en SiO2) ;
- une reprise de contact 19b.

Il est clairement indiqué en paragraphe [055] que le PZT 15 est cristallisé. Mais il n'est pas explicité ce qui est fait au niveau de la seconde couche de PZT 17 et l'utilisation qui serait faite de cette couche en tant qu'isolant électrique dans la mesure où il est nécessairement prévu une couche d'isolation électrique 18.

Dans ce contexte, la présente invention a pour objet un composant de type capacité intégrée utilisant un diélectrique d'isolation électrique ne présentant pas les inconvénients précités et dont le procédé de fabrication s'avère être particulièrement intéressant.

Plus précisément la présente invention a pour objet une capacité intégrée comprenant une couche de matériau diélectrique dit fonctionnel à base de matériau cristallisé de type pérovskite, comprise entre au moins une première électrode dite inférieure à la surface d'un substrat et au moins d'une deuxième électrode dite supérieure, lesdites électrodes étant isolées électriquement par une couche de matériau isolant électrique pour permettre au moins une reprise de contact sur l'électrode supérieure, caractérisée en ce que :
- le matériau isolant électrique est en matériau diélectrique amorphe de type pérovskite présentant une constante diélectrique inférieure à celle du matériau cristallisé de type pérovskite et
- la reprise de contact est formée à partir d'une couche de reprise de contact gravée en contact avec la couche de diélectrique isolant électrique au niveau de sa surface parallèle au plan des couches.

Selon une variante de l'invention, le matériau isolant électrique est disposé sur ou sous l'électrode supérieure.

Selon une variante de l'invention, le matériau diélectrique fonctionnel cristallisé est un oxyde parmi les oxydes suivants : Pb(Sr,Ti)O₃, SrTiO₃, (Ba,Sr)TiO₃, (Pb,La)(Zr,Ti)O₃, Pb(Mg,Nb,Ti)O₃, Pb(Zn,Nb,Ti)O₃, BiFeO₃, BaTiO₃.

Selon une variante de l'invention, le matériau diélectrique isolant électrique amorphe est un oxyde parmi les oxydes suivants : PZT, SrTiO₃, (Ba,Sr)TiO₃, (Pb,La)(Zr,Ti)O₃, Pb(Mg,Nb,Ti)O₃, Pb(Zn,Nb,Ti)O₃, BiFeO₃, BaTiO₃.

Selon une variante de l'invention, les matériaux diélectriques fonctionnel et isolant électrique sont de même composition chimique.

Selon une variante de l'invention, les électrodes sont en platine ou en ruthénium, ou en oxyde de ruthénium, ou en iridium, ou en oxyde d'iridium, ou en or.

Selon une variante de l'invention, le substrat est en silicium et comporte une couche supérieure d'oxyde.

Selon une variante de l'invention, la capacité comporte en outre une couche d'accrochage entre le substrat et la couche d'électrode inférieure.

L'invention a aussi pour obet un procédé de fabrication d'une capacité intégrée selon l'invention, caractérisé en ce qu'il comprend au moins une étape de réalisation d'une couche de matériau diélectrique amorphe et isolant électrique, au dessus ou au dessous de l'électrode supérieure, par procédé sol-gel comportant :
- l'étalement d'une solution sol-gel ;
- le séchage de ladite solution à une température comprise entre environ 100°C et 150°C ;
- la pyrolyse de ladite solution séchée à une température comprise entre environ 300°C et 500°C conduisant au matériau diélectrique isolant amorphe.

Selon une variante de l'invention, le procédé comprend au moins :
- une étape de réalisation d'une couche de matériau diélectrique fonctionnel cristallisé (DF_{cris}) entre l'électrode inférieure et l'électrode supérieure par procédé sol-gel comportant :
- l'étalement d'une solution sol-gel à la surface d'un substrat comportant une électrode inférieure ;
- le séchage de ladite solution à une température comprise entre environ 100°C et 150°C ;
- la pyrolyse de ladite solution séchée à une température comprise entre environ 300°C et 500°C conduisant à un matériau diélectrique fonctionnel amorphe;
- la cristallisation dudit matériau fonctionnel amorphe porté à une température supérieure ou égale à la température de cristallisation dudit matériau de manière à obtenir le matériau diélectrique fonctionnel cristallisé (DF_{cris}).

Selon une variante de l'invention, la cristallisation est effectuée par recuit rapide (RTA).

Ainsi la présente invention propose notamment avantageusement d'utiliser un procédé de type sol-gel dans un mode pouvant apparaître comme un mode « dégradé » ne donnant pas de couches cristallisées pour le matériau amorphe, puisque la réalisation de ce dernier, s'arrête après l'étape de calcination, sans réaliser l'étape de cristallisation, qui requière une opération de recuit à plus haute température.

L'invention sera mieux comprise et d'autres avantages apparaîtront à la lecture de la description qui va suivre donnée à titre non limitatif et grâce aux figures annexées parmi lesquelles :
- la figure 1 illustre un exemple de structure capacité MIM selon l'art connu ;
- la figure 2 illustre un exemple d'utilisation d'un diélectrique d'isolation pour reprendre les contacts sur la capacité MIM selon l'art connu ;
- la figure 3 illustre l'apparition de défauts dans le PZT, dus à la présence d'hydrogène dans un verre non dopé de silice ;
- les figures 4a et 4b illustrent deux exemples de procédés d'étalement de type sol-gel sur un substrat par enduction centrifuge et par trempage-retrait ;
- les figures 5a et 5b illustrent un exemple d'empilement pour une capacité à forte permittivité selon l'invention avec électrode inférieure non gravée ou gravée ;
- les étapes 6a à 6k illustrent les différentes étapes d'un procédé de fabrication d'une capacité intégrée selon l'invention.

Selon l'invention, il est proposé d'utiliser un procédé sol-gel permettant de réaliser des composants présentant une couche diélectrique de forte permittivité et une couche de matériau ayant une permittivité plus faible assurant une fonction d'isolation électrique entre les deux types d'électrodes dite inférieure et supérieure.

Dans le cas de matériaux à très forte permittivité, une technique connue est le procédé sol gel et notamment de type polymérisation sol-gel. Le dépôt par voie sol-gel de PbTiO₃ (PT) a été rapporté pour la première fois en 1984 par GURKOVICH S. R., Blum J. B., Préparation of monolithic lead-titanate by sol-gel process, in Ultrastructure Processing of Ceramics, Glasses and Composites, L.L.Ha.D.R. Ulrich, Editor, Wiley-Interscience: New-York, 152-160, 1984.

L'année suivante, Budd ans al., BUDD K. D., Dey S. K., PAYNE D. A., Sol-gel processing of PT, PZ, PZT and PLZT thin films. Br. Ceram. Proc. 107-121, 1985, ont décrit la synthèse de films minces pérovskites à base de plomb (PT, PZ, PZT, PLZT).

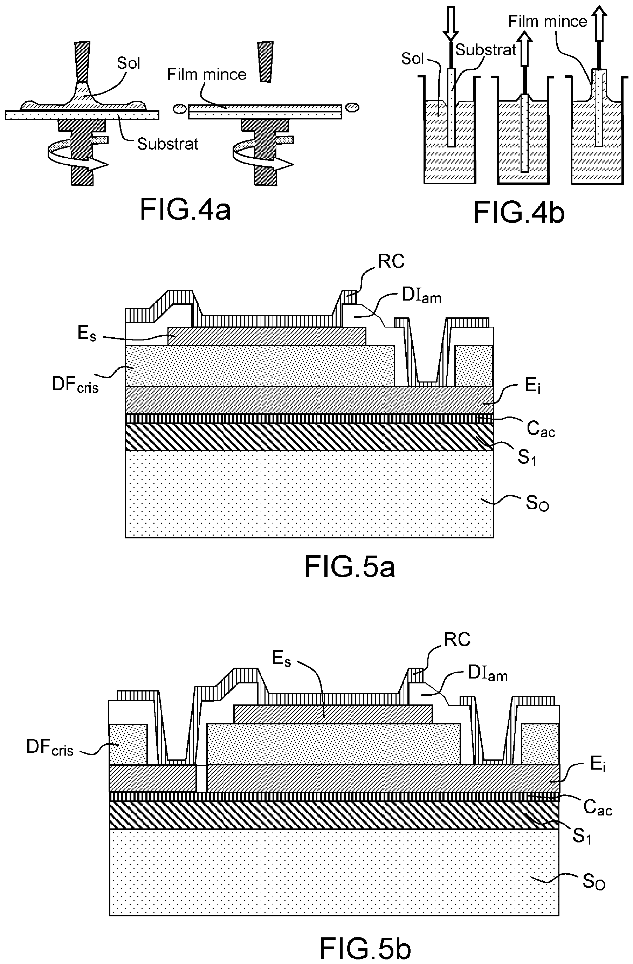

Ce procédé utilise une solution contenant des précurseurs réactifs tels que les sels métalliques ou les alcoxydes, et un solvant. Le dépôt des couches minces peut se faire par enduction centrifuge (spin-coating) ou bien par trempage-retrait (dip-coating) comme illustré sur les figures 4a et 4b.

Le principe du procédé sol-gel repose sur une succession de réactions d'hydrolyse-condensation, à une température proche de l'ambiante, qui conduit à la formation d'un polymère minéral, lequel peut ensuite être traité thermiquement. L'étape d'hydrolyse des alcoxydes métalliques est schématisée par la réaction suivante :

M-OR + H₂O → M-OH + ROH

où M est un cation métallique, et R un groupe organique alkyl. Cette réaction permet la conversion des fonctions alcoxy en fonction hydroxy. La solution obtenue est appelée *sol* ; c'est-à-dire une phase solide, constituée de petites entités, dispersée dans un liquide (le solvant). Les fonctions hydroxy sont ensuite converties en espèces M-O-M correspondant à la formation d'un réseau macromoléculaire minéral constituant le *gel.* Cela se fait suivant plusieurs réactions de condensation (formation de ponts oxo, -O-, par réactions d'oxolation) avec élimination d'alcool et d'eau.

M-OH + M-OR → M-O-M + ROH

M-OH + M-OH → M-O-M + H₂0

La réalisation des films piézoélectriques par la technique sol-gel consiste en une succession d'étapes d'étalement de la solution sol-gel et de traitements thermiques, comme schématisé ci-après :

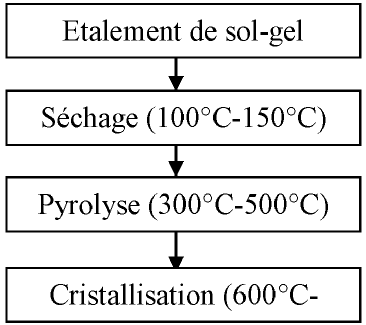

La solution est habituellement étalée sur un substrat par enduction centrifuge. L'épaisseur de film déposée dépend principalement de la vitesse de rotation de la tournette et des paramètres physico-chimiques de la solution (viscosité, concentration, taux d'évaporation). Une étape de séchage permet d'évaporer une partie des solvants et d'obtenir un dépôt solide. La couche subit ensuite une pyrolyse (ou calcination) afin d'éliminer les résidus organiques.

Cette étape, généralement effectuée sur plaque chauffante, est cruciale car elle conditionne grandement la qualité structurale du film piézoélectrique. La température de calcination doit être suffisamment élevée afin d'éliminer la totalité des résidus organiques (typiquement comprise entre 300°C et 450°C). Dans le cas contraire, le piégeage de matière organique peut conduire à la présence de porosités. Cependant, une température trop élevée risque de favoriser l'apparition de phase parasite, comme la pyrochlore dans le cas du PZ, décrit dans la publication : GONG W., L J. F., C_{HU} X., L 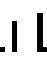 L., J. Eur. Ceram. Soc. 24, 2977-2982, 2004.

Après pyrolyse, la couche amorphe obtenue est cristallisée et densifiée à une température comprise entre 600°C et 800°C. Cette étape de cristallisation est le plus souvent réalisée par recuit rapide RTA acronyme de l'appelation « Rapid Thermal Annealing », plutôt que par recuit conventionnel, afin notamment de limiter le budget thermique. Le procédé de recuit rapide RTA est aujourd'hui parmi les plus utilisés pour la cristallisation des films minces. Son principal atout est une transmission de l'énergie thermique par rayonnement et non par convection. Il en résulte des montées en température extrêmement rapide pouvant atteindre jusqu'à 300°C/s grâce à l'utilisation de lampes halogènes. Les recuits durent quelques dizaines de secondes. L'épaisseur d'une couche après cristallisation est généralement d'environ 50 nm. Suivant l'épaisseur finale de matériau désirée, il faut répéter à plusieurs reprises l'ensemble des étapes précédemment décrites. Toutefois, l'étape de cristallisation est bien souvent effectuée toutes les deux ou trois couches pyrolysées. On comprend alors l'intérêt d'utiliser le procédé RTA afin de réduire à la fois le budget thermique et le temps de fabrication des films.

Le procédé sol-gel présente l'avantage d'être peu onéreux et relativement simple à mettre en œuvre, ne nécessitant qu'une piste d'étalement, des plaques chauffantes et un four RTA. De plus, il ne requiert pas une maintenance importante, ce qui est un atout non négligeable par rapport aux techniques de dépôt sous vide. Il est par ailleurs très flexible pour le développement de matériaux complexes. On peut ainsi facilement faire varier les compositions par le biais du dosage des précurseurs organométalliques, ou bien incorporer des dopants pour optimiser les propriétés des films.

De manière générale, le matériau déposé par procédé sol gel subit plusieurs étapes. Après pyrolyse, le matériau a été débarrassé de tous ses composés organiques (donc H et C). Le matériau résultant est donc exclusivement composé de matières non organiques après cette pyrolyse (parfois appelé calcination). Comme le matériau n'est pas cristallisé, il ne possède pas de constante diélectrique très élevée.

La présente invention propose d'exploiter cette propriété de plus faible constante diélectrique pour utiliser cette couche appelée calcinée ou pyrolysée, comme diélectrique d'isolation DI comme illustré en figure 2. Cela présente l'avantage de permettre d'utiliser un matériau unique comme diélectrique d'isolation DI et diélectrique fonctionnel DF, le diélectrique d'isolation DI ne possède pas de composés hydrogénés susceptibles d'abimer les propriétés du diélectrique fonctionnel DF, la constante diélectrique du diélectrique d'isolation DI reste faible comparée à celle du diélectrique fonctionnel DF (typiquement pour le PZT, la constante diélectrique du PZT calciné non cristallisé se situe entre 20 et 30, alors que la constante diélectrique du PZT cristallisé se situe entre 400 et 1500).

### Exemple de procédé de réalisation selon l'invention :

La capacité intégrée selon l'invention comprend dans cet exemple un matériau diélectrique fonctionnel de type pérovskite présentant une constante diélectrique élevée pouvant notamment être du PZT et un isolant électrique de type diélectrique de type pérovskite amorphe n'ayant pas subi de phase finale de recuit de cristallisation, entre l'électrode inférieure et l'électrode supérieure, comme illustré en figure 5 qui montre un empilement possible pour une capacité intégrée de très forte valeur utilisant du PZT comme diélectrique d'isolation DIₐₘ (calciné) et diélectrique fonctionnel DF_{cris} (cristallisé), à partir d'un substrat S₀ recouvert d'une couche d'oxyde S₁ et d'une couche d'accrochage C_{ac} et comportant une électrode inférieure Ei et une électrode supérieure Es.

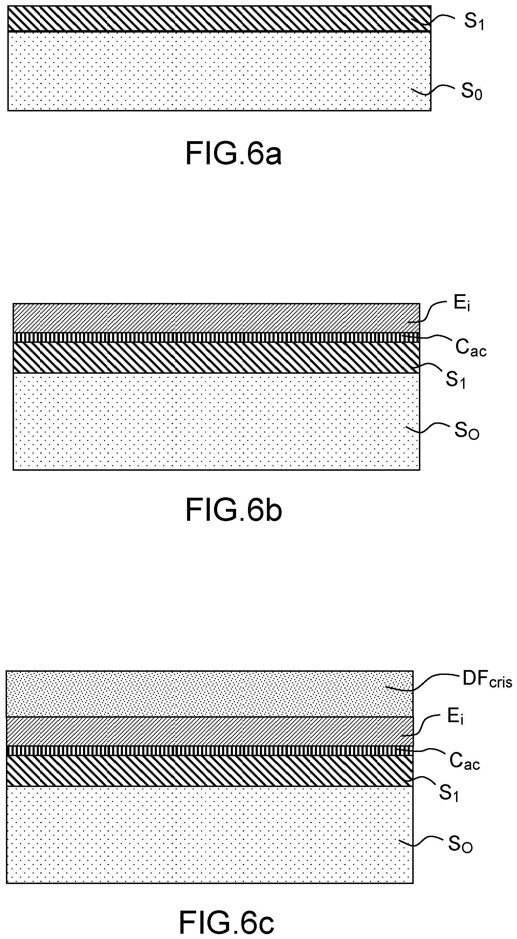

Les différentes étapes du procédé sont décrites ci-après à l'aide des figures 6a à 6k.

Pour réaliser un tel empilement, on peut utiliser un substrat silicium S₀, typiquement de 200mm de diamètre. On procède à une étape d'oxydation définissant une couche surfacique S₁ de SiO₂ d'épaisseur de 500nm, comme illustré en figure 6a. Cela permet de prévenir les diffusions vers le substrat.

On réalise alors le dépôt d'une couche d'accroche C_{ac} faite par pulvérisation de 5nm de titane Ti suivi d'une oxydation par recuit rapide de 2 minutes à 750°C sous oxygène O₂. Cette couche d'accroche peut être également faite en tantaleTa.

On réalise le dépôt de l'électrode inférieure Ei comme illustré en figure 6b, en Pt (100nm) par pulvérisation. Cette électrode peut également être en iridium. L'électrode inférieure peut ou non être gravée par exemple par usinage ionique selon un motif approprié.

On procède à la réalisation du diélectrique fonctionnel en PZT par procédé sol gel comme évoqué selon le schéma réactionnel précédemment décrit, référencé DF_{cris} et illustré en figure 6c. Typiquement, on peut déposer 200 nm de PZT en faisant au moins un dépôt à la tournette, suivi d'une d'opération de séchage à 110°C durant 5 minutes sur une plaque chauffante, et d'une étape de pyrolyse à 350°C durant 5 minutes sur plaque chauffante. Dans le cas de l'utilisation de dépôt successifs pour obtenir l'épaisseur souhaité de PZT, chaque dépôt est suivi d'une opération de séchage et de pyrolyse avant le dépôt suivant.

On procède alors à une opération de recuit final de cristallisation à 700°C sous air pendant 30 secondes. Généralement ce recuit doit-être réalisé tous les 3 (dépôt/séchage/ pyrolyse) de PZT.

Il est possible d'utiliser d'autres matériaux que le PZT, à très forte permittivité pouvant être notamment l'un des oxydes suivants : SrTiO₃, (Ba,Sr)TiO₃, (Pb,La)(Zr,Ti)O₃, Pb(Mg,Nb,Ti)O₃, Pb(Zn,Nb,Ti)O₃, BiFeO₃, BaTiO₃.

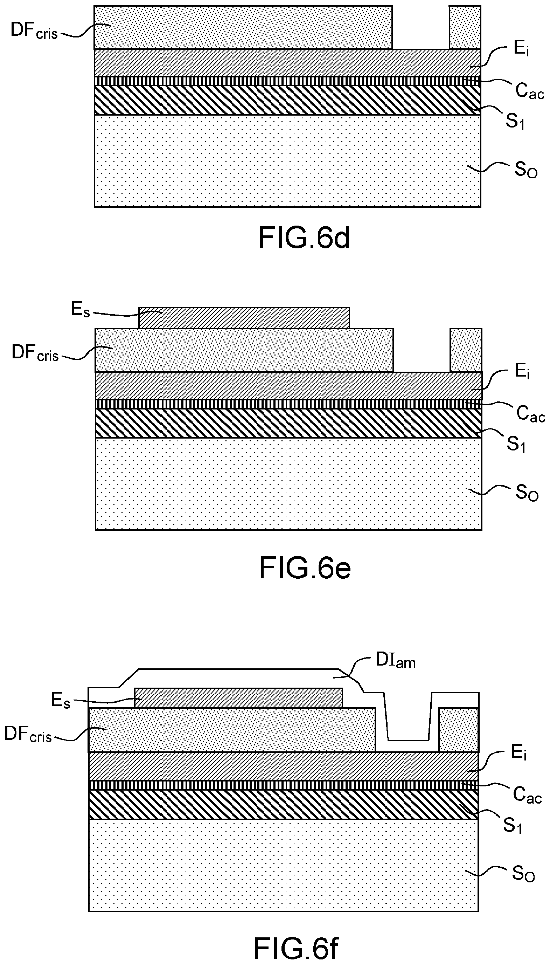

Le PZT est ensuite gravé par un procédé dit humide à base de la préparation suivante: HF à 1%, HCl à 37% dans de l'eau et dans les proportions relatives suivantes : 5/ 9/ 50. Cette gravure peut également être faire par gravure sèche en utilisant un équipement de RIE (Reactive Ion Etching) avec des gaz de type chloré avec adjonction d'argon comme illustré en figure 6d. La définition de cette gravure se fait en utilisant préalablement à la gravure une résine photosensible définie par une étape de photolithographie en utilisant un masque dédié.

On procède alors au dépôt par pulvérisation de l'électrode supérieure Es en Pt d'épaisseur typiquement de 100nm comme illustré en figure 6e. Cette électrode peut être tout aussi bien être en ruthénium, ou oxyde de ruthénium, en iridium, ou en oxyde d'iridium, ou bien encore en or. Cette électrode est gravée par usinage ionique. La définition de cette gravure se fait en utilisant préalablement à la gravure une résine photosensible définie par une étape de photolithographie en utilisant un masque dédié.

On dépose ensuite le diélectrique d'isolation par procédé sol gel mais en ne faisant pas l'étape finale de cristallisation, référencé DIₐₘ et illustré en figure 6f. Dans ce cas, on utilise du PZT ou d'autres matériaux pouvant notamment être du SrTiO₃, (Ba,Sr)TiO₃, (Pb,La)(Zr,Ti)O₃, Pb(Mg,Nb,Ti)O₃, Pb(Zn,Nb,Ti)O₃, BiFeO₃, BaTiO₃). Typiquement la couche de diélectrique d'isolation peut avoir une épaisseur de l'ordre de 400nm environ, obtenue par six dépôts calcinés réalisés par dépôts à la tournette, suivis d'une opération de séchage à 110°C pendant 5 minutes sur plaque chauffante, suivie d'une opération de pyrolyse à 350°C durant 5 minutes sur plaque chauffante, réitérée six fois. Il est possible de diminuer ou d'augmenter l'épaisseur en réduisant ou en augmentant le nombre de dépôt (dépôt tournette + séchage à 110°C durant 5minutes sur plaque chauffante + pyrolyse à 350°C durant 5 minutes sur plaque chauffante) ou la viscosité du liquide sol gel.

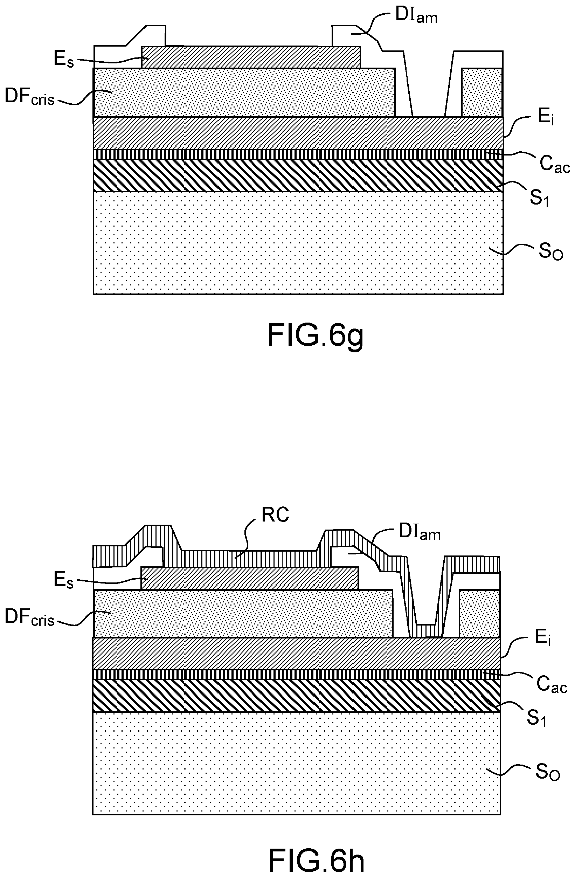

Ce diélectrique d'isolation est ensuite gravé par procédé humide à base de la préparation HF 1% - HCl 37% - H₂O dans les proportions 5/9/200 . La définition de cette gravure se fait en utilisant préalablement à la gravure une résine photosensible définie par une étape de photolithographie en utilisant un masque dédié comme illustré en figure 6g.

On dépose ensuite un métal pour faire la reprise de contact Rc comme illustré en figure 6h. Ce métal peut être de manière non limitative de l'Al, de l'Al/Cu, de l'Al/Si, du Cu, du Pt....On peut notamment utiliser un alliage Al/Cu1% sur 1µm d'épaisseur, déposé par pulvérisation.

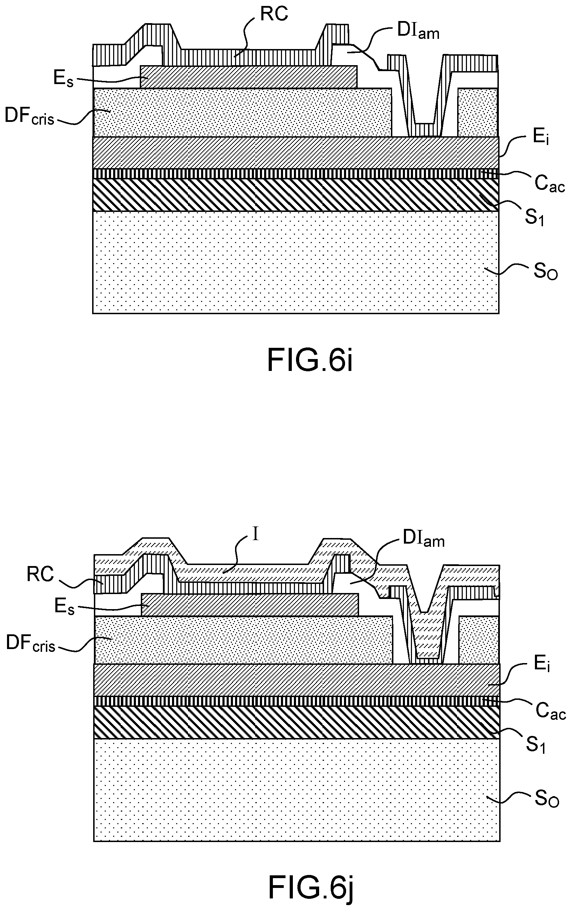

Cette couche est ensuite gravée par procédé humide ou sec comme illustré en figure 6i. La définition de cette gravure se fait en utilisant préalablement à la gravure une résine photosensible définie par une étape de photolithographie en utilisant un masque dédié.

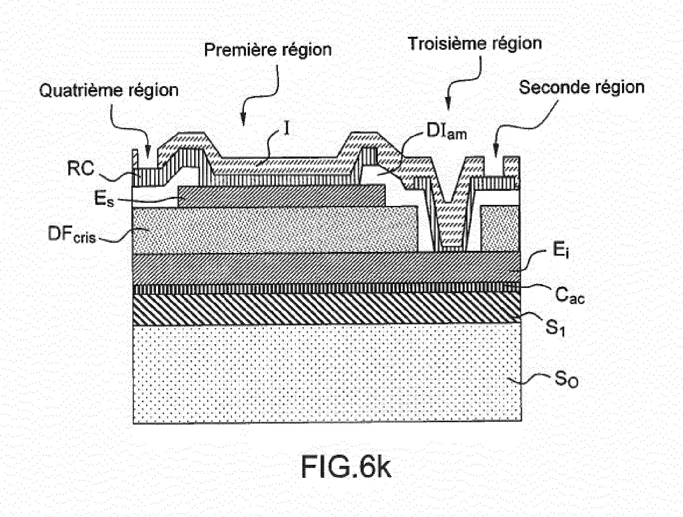

On dépose enfin une couche isolante de protection I comme illustré en figure 6j, qui est gravée afin d'accéder à la couche de contact Rc comme illustré en figure 6k.

## Revendications

1. Capacité intégrée comprenant une couche de matériau diélectrique dit fonctionnel (DF_{cris}) à base de matériau cristallisé de type pérovskite, comprise entre au moins une première électrode dite inférieure (Ei) à la surface d'un substrat et au moins d'une deuxième électrode dite supérieure (Es) comprenant un premier bord et un second bord opposé audit premier bord, lesdites électrodes étant isolées électriquement par une couche de matériau isolant électrique (Diₐₘ) pour permettre au moins une reprise de contact sur l'électrode supérieure, **caractérisée en ce qu'**elle comprend l'empilement de couches suivant à la surface du matériau fonctionnel (DF_{cris}) :
- la couche de matériau isolant électrique (Diₐₘ) ;
- une couche de reprise de contact localement gravée (Rc);
- une couche protectrice isolante (I) ;
- la couche de reprise de contact (Rc) est:
o localement en contact et au dessus de la surface de l'électrode supérieure ;
∘ localement en contact et au dessus de la surface de l'électrode inférieure ;
∘ localement en contact et au dessus de la surface de la couche de matériau isolant électrique (Dᵢₐₘ) ;
- la couche de matériau isolant électrique (Dᵢₐₘ) est gravée afin d'exposer des parties des surfaces supérieures des électrodes inférieure et supérieure, lesdites surfaces définissant un premier contact entre la couche de contact gravée (Rc) et la surface de l'électrode supérieure et un deuxième contact ente la couche de contact gravée et la surface de l'électrode inférieure ;
- la couche de matériau fonctionnel (DF_{cris}) est gravée afin d'exposer une partie de la surface supérieure de l'électrode inférieure et afin de permettre l'accès pour ledit troisième contact ;
- la couche protectrice isolante (I) est gravée au dessus de la couche de contact gravée, pour définir un troisième contact de la couche de contact gravée (Rc) s'étendant horizontalement au-delà du premier bord de l'électrode supérieure et un quatrième contact de la couche de contact gravée s'étendant horizontalement au-delà du second bord opposé de l'électrode supérieure ;
- le matériau isolant électrique est en matériau diélectrique amorphe de type pérovskite (DIₐₘ) présentant une constante diélectrique inférieure à celle du matériau cristallisé de type pérovskite et
le matériau diélectrique isolant électrique amorphe est un oxyde parmi les oxydes suivants : PZT, SrTiO₃, (Ba,Sr)TiO₃, (Pb,La)(Zr,Ti)O₃, Pb(Mg,Nb,Ti)O₃, Pb(Zn,Nb,Ti)O₃, BiFeO₃, BaTiO₃ ;
le substrat (S₀) étant recouvert d'une couche supérieure d'oxyde (S₁) ;
- ladite capacité comportant une couche d'accrochage entre le substrat et la couche d'électrode inférieure (C_{ac}).

2. Capacité intégrée selon la revendication 1, **caractérisée en ce que** le matériau isolant électrique est disposé sur ou sous l'électrode supérieure.

3. Capacité intégrée selon l'une des revendications 1 ou 2, **caractérisée en ce que** le matériau diélectrique fonctionnel cristallisé est un oxyde parmi les oxydes suivants : Pb(Sr,Ti)O₃, SrTiO₃, (Ba,Sr)TiO₃, (Pb,La)(Zr,Ti)O₃, Pb(Mg,Nb,Ti)O₃, Pb(Zn,Nb,Ti)O₃, BiFeO₃, BaTiO₃.

4. Capacité intégrée selon l'une des revendications 1 à 3, **caractérisé en ce que** les matériaux diélectriques fonctionnel et isolant électrique sont de même composition chimique.

5. Capacité intégrée selon l'une des revendications 1 à 4, **caractérisée en ce que** les électrodes sont en platine ou en ruthénium, ou en oxyde de ruthénium, ou en iridium, ou en oxyde d'iridium, ou en or.

6. Capacité intégrée selon l'une des revendications 1 à 5, **caractérisée en ce que** le substrat est en silicium S₀.

7. Procédé de fabrication d'une capacité intégrée selon l'une des revendications 1 à 6, **caractérisé en ce qu'**il comprend au moins une étape de réalisation d'une couche de matériau diélectrique amorphe et isolant électrique (DI ₐₘ), au dessus ou au dessous de l'électrode supérieure, par procédé sol-gel comportant :
- l'étalement d'une solution sol-gel ;
- le séchage de ladite solution à une température comprise entre environ 100°C et 150°C ;
- la pyrolyse de ladite solution séchée à une température comprise entre environ 300°C et 500°C conduisant au matériau diélectrique isolant amorphe (DIₐₘ).

8. Procédé de fabrication d'une capacité intégrée selon la revendication 7, **caractérisé en ce qu'**il comprend au moins une étape de réalisation d'une couche de matériau diélectrique fonctionnel cristallisé (DF_{cris}) entre l'électrode inférieure et l'électrode supérieure par procédé sol-gel comportant :
- l'étalement d'une solution sol-gel à la surface d'un substrat comportant une électrode inférieure ;
- le séchage de ladite solution à une température comprise entre environ 100°C et 150°C ;
- la pyrolyse de ladite solution séchée à une température comprise entre environ 300°C et 500°C conduisant à un matériau diélectrique fonctionnel amorphe;
- la cristallisation dudit matériau fonctionnel amorphe porté à une température supérieure ou égale à la température de cristallisation dudit matériau de manière à obtenir le matériau diélectrique fonctionnel cristallisé (DF_{cris}).

9. Procédé de fabrication d'une capacité intégrée selon la revendication 8, **caractérisé en ce que** la cristallisation est effectuée par recuit rapide (RTA).

## Patentansprüche

1. Integrierter Kondensator, der eine Schicht aus dielektrischem, sogenanntem funktionellem Material (DF_{cris}) auf der Basis von kristallinem Material vom Typ Perowskit umfasst, die zwischen mindestens einer ersten, sogenannten unteren Elektrode (Ei) an der Oberfläche eines Substrats und mindestens einer zweiten, sogenannten oberen Elektrode (Es), die einem ersten Rand und einem zweiten Rand, der dem ersten Rand gegenüber liegt, umfasst, umfasst ist, wobei die Elektroden durch eine Schicht aus elektrisch isolierendem Material (Diₐₘ) elektrisch isoliert sind, um mindestens eine Wiederherstellung des Kontakts mit der oberen Elektrode zu ermöglichen, **dadurch gekennzeichnet, dass** sie den folgenden Schichtstapel an der Oberfläche des funktionellen Materials (DF_{cris}) umfasst:
- die Schicht aus elektrisch isolierendem Material (Diₐₘ);
- eine lokal geätzte Kontaktwiederherstellungsschicht (Rc);
- eine isolierende Schutzschicht (I);
- die Kontaktwiederherstellungsschicht (Rc) ist:
∘ lokal in Kontakt mit und oberhalb der Oberfläche der oberen Elektrode;
∘ lokal in Kontakt mit und oberhalb der Oberfläche der unteren Elektrode;
∘ lokal in Kontakt mit und oberhalb der Oberfläche der Schicht aus elektrisch isolierendem Material (Diₐₘ);
- die Schicht aus elektrisch isolierendem Material (Diₐₘ) wird geätzt, um Teile der oberen Oberflächen der unteren und oberen Elektroden freizulegen, wobei die Oberflächen einen ersten Kontakt zwischen der geätzten Kontaktschicht (Rc) und der Oberfläche der oberen Elektrode sowie einen zweiten Kontakt zwischen der geätzten Kontaktschicht und der Oberfläche der unteren Elektrode definieren;
- die Schicht aus funktionellem Material (DF_{cris}) wird geätzt, um einen Teil der oberen Oberfläche der unteren Elektrode freizulegen und um den Zugang für den dritten Kontakt zu ermöglichen;
- die isolierende Schutzschicht (I) wird über der geätzten Kontaktschicht geätzt, um einen dritten Kontakt der geätzten Kontaktschicht (Rc), der sich horizontal über den ersten Rand der oberen Elektrode hinaus erstreckt, und einen vierten Kontakt der geätzten Kontaktschicht zu definieren, der sich horizontal über den zweiten, gegenüberliegenden Rand der oberen Elektrode hinaus erstreckt;
- das elektrisch isolierende Material besteht aus amorphem dielektrischem Material vom Typ Perowskit (DIₐₘ), dessen Dielektrizitätskonstante geringer ist als die des kristallinen Materials vom Typ Perowskit, und
- das amorphe elektrisch isolierende dielektrische Material ist ein Oxid aus den folgenden Oxiden: PZT, SrTiO₃, (Ba,Sr)TiO₃, (Pb,La)(Zr,Ti)O₃, Pb(Mg,Nb,Ti)O₃, Pb(Zn,Nb,Ti)O₃, BiFeO₃, BaTiO₃;
wobei das Substrat (S₀) mit einer oberen Oxidschicht (S₁) bedeckt ist;
- wobei der Kondensator eine Haftschicht zwischen dem Substrat und der unteren Elektrodenschicht (C_{ac}) aufweist.

2. Integrierter Kondensator nach Anspruch 1, **dadurch gekennzeichnet, dass** das elektrisch isolierende Material auf oder unter der oberen Elektrode angeordnet ist.

3. Integrierter Kondensator nach Anspruch 1 oder 2, **dadurch gekennzeichnet, dass** das kristallisierte funktionelle dielektrische Material ein Oxid aus den folgenden Oxiden ist: Pb(Sr,Ti)O₃, SrTiO₃, (Ba,Sr)TiO₃, (Pb,La)(Zr,Ti)O₃, Pb(Mg,Nb,Ti)O₃, Pb(Zn,Nb,Ti)O₃, BiFeO₃, BaTiO₃.

4. Integrierter Kondensator nach einem der Ansprüche 1 bis 3, **dadurch gekennzeichnet, dass** die funktionellen und elektrisch isolierenden dielektrischen Materialien dieselbe chemische Zusammensetzung haben.

5. Integrierter Kondensator nach einem der Ansprüche 1 bis 4, **dadurch gekennzeichnet, dass** die Elektroden aus Platin oder Ruthenium oder Rutheniumoxid oder Iridium oder Iridiumoxid oder Gold bestehen.

6. Integrierter Kondensator nach einem der Ansprüche 1 bis 5, **dadurch gekennzeichnet, dass** das Substrat aus S₀-Silicium besteht.

7. Verfahren zur Herstellung eines integrierten Kondensators nach einem der Ansprüche 1 bis 6, **dadurch gekennzeichnet, dass** es mindestens einen Schritt zur Herstellung einer Schicht aus amorphem dielektrischem und elektrisch isolierendem Material (DIₐₘ) oberhalb oder unterhalb der oberen Elektrode durch ein Sol-Gel-Verfahren umfasst, das Folgendes beinhaltet:
- Verteilen einer Sol-Gel-Lösung;
- Trocknen der Lösung bei einer Temperatur zwischen etwa 100°C und 150°C;
- Pyrolysieren der getrockneten Lösung bei einer Temperatur zwischen etwa 300°C und 500°C, was zu amorphem dielektrischem Isoliermaterial (DIₐₘ) führt.

8. Verfahren zur Herstellung eines integrierten Kondensators nach Anspruch 7, **dadurch gekennzeichnet, dass** es mindestens einen Schritt zur Herstellung einer Schicht aus kristallisiertem funktionellem dielektrischem Material (DF_{cris}) zwischen der unteren Elektrode und der oberen Elektrode durch ein Sol-Gel-Verfahren umfasst, das Folgendes beinhaltet:
- Verteilen einer Sol-Gel-Lösung auf der Oberfläche eines Substrats, das eine untere Elektrode umfasst;
- Trocknen der Lösung bei einer Temperatur zwischen etwa 100°C und 150°C;
- Pyrolysieren der getrockneten Lösung bei einer Temperatur zwischen etwa 300°C und 500°C, was zu einem amorphen funktionellen dielektrischen Material führt;
- Kristallisieren des amorphen funktionellen Materials bei einer Temperatur, die gleich der oder höher als die Kristallisationstemperatur des Materials ist, um das kristallisierte funktionelle dielektrische Material (DF_{cris}) zu erhalten.

9. Verfahren zur Herstellung eines integrierten Kondensators nach Anspruch 8, **dadurch gekennzeichnet, dass** die Kristallisation durch schnelles Glühen (RTA) erfolgt.

## Claims

1. An integrated capacitor comprising a layer of so-called functional dielectric material (DF_{cris}) based on crystallised material of perovskite type, comprised between at least one first so-called bottom electrode (Ei) at the surface of a substrate and at least one second so-called top electrode (Es) comprising a first edge and a second edge opposite said first edge, said electrodes being electrically insulated by a layer of electrically insulating material (Diₐₘ) in order to allow at least one re-contact on the top electrode, **characterised in that** it comprises the following stack of layers on the surface of the functional material (DF_{cris}):
- the layer of electrically insulating material (Diₐₘ);
- a locally etched contact recovery layer (Rc);
- an insulating protective layer (I);
- the contact recovery layer (Rc) is:
∘ locally in contact with and above the surface of the top electrode;
∘ locally in contact with and above the surface of the bottom electrode;
o locally in contact with and above the surface of the layer of electrically insulating material (Diₐₘ);
- the layer of electrically insulating material (Dᵢₐₘ) is etched in order to expose portions of the top surfaces of the lower and top electrodes, said surfaces defining a first contact between the etched contact layer (Rc) and the surface of the top electrode and a second contact between the etched contact layer and the surface of the bottom electrode;
- the layer of functional material (DF_{cris}) is etched in order to expose part of the top surface of the bottom electrode and in order to allow access for said third contact;
- the insulating protective layer (I) is etched above the etched contact layer, to define a third contact of the etched contact layer (Rc) extending horizontally over the first edge of the top electrode and a fourth contact of the etched contact layer extending horizontally over the second opposite edge of the top electrode;
- the electrically insulating material is made of an amorphous dielectric material of perovskite type (DIₐₘ) having a dielectric constant lower than that of the crystallised material of perovskite type and
the amorphous electrically insulating dielectric material is an oxide of the following oxides PZT, SrTiO₃, (Ba,Sr)TiO₃, (Pb,La)(Zr,Ti)O₃, Pb(Mg,Nb,Ti)O₃, Pb(Zn,Nb,Ti)O₃, BiFeO₃, BaTiO₃;
the substrate (S₀) being covered with a top layer of oxide (S₁);
- said capacitor having a bonding layer between the substrate and the bottom electrode layer (C_{ac}).

2. The integrated capacitor according to claim 1, **characterised in that** the electrically insulating material is disposed on or under the top electrode.

3. The integrated capacitor according to one of claims 1 or 2, **characterised in that** the crystallised functional dielectric material is an oxide from among the following oxides: Pb(Sr,Ti)O₃, SrTiO₃, (Ba,Sr)TiO₃, (Pb,La)(Zr,Ti)O₃, Pb(Mg,Nb,Ti)O₃, Pb(Zn,Nb,Ti)O₃, BiFeO₃, BaTiO₃.

4. The integrated capacitor according to one of claims 1 to 3, **characterised in that** the functional and electrically insulating dielectric materials have the same chemical composition.

5. The integrated capacitor according to one of claims 1 to 4, **characterised in that** the electrodes are made of platinum or of ruthenium, or of ruthenium oxide, or of iridium, or of iridium oxide, or of gold.

6. The integrated capacitor according to one of claims 1 to 5, **characterised in that** the substrate is made of silicon S₀.

7. A process for manufacturing an integrated capacitor according to one of claims 1 to 6, **characterised in that** it comprises at least one step of producing a layer of amorphous and electrically insulating dielectric material (DIₐₘ), on top of or underneath the top electrode, via a sol-gel process containing the steps of:
- spreading a sol-gel solution;
- drying said solution at a temperature between around 100°C and 150°C;
- pyrolysis of said dried solution at a temperature between around 300°C and 500°C resulting in the amorphous insulating dielectric material (DIₐₘ).

8. The process for manufacturing an integrated capacitor according to claim 7, **characterised in that** it comprises at least one step of producing a layer of crystallised functional dielectric material (DF_{cris}) between the bottom electrode and the top electrode via a sol-gel process containing the steps of:
- spreading a sol-gel solution on the surface of a substrate comprising a bottom electrode;
- drying said solution at a temperature between around 100°C and 150°C;
- pyrolysis of said dried solution at a temperature between around 300°C and 500°C resulting in an amorphous functional dielectric material;
- crystallisation of said amorphous functional material brought to a temperature greater than or equal to the crystallisation temperature of said material so as to obtain the crystallised functional dielectric material (DF_{cris}).

9. The process for manufacturing an integrated capacitor according to claim 8, **characterised in that** the crystallisation is carried out by rapid thermal annealing (RTA).
